# EUROPEAN PATENT APPLICATION

(11) **EP 0 552 039 A1**
(43) Date of publication of application: **21.07.1993**
(21) Application number: 93300236.2
(22) Date of filing: 14.01.1993
(51) Int. Cl.: H03F 3/24, H04B 1/04, H03F 1/52

(54) **Transmitter tuning**

(30) Priority: 17.01.1992 GB 9200956; 05.05.1992 GB 9209657
(71) Applicant: GEC-MARCONI LIMITED, Stanmore, Middlesex HA7 4LY (GB)
(72) Inventor: Pike Tudor David, Maldon, Essex CM9 6AN (GB)
(74) Representative: Cockayne, Gillian

(57) **Abstract**

A method of tuning a single sideband transmitter by measuring the output power and power dissipation of the output valve and alternately adjusting the input signal voltage and the load presented by the output filter network until the output power and power dissipation values correspond to the desired operating point and output power, the load presented by the output network being kept effectively real.

## Description

This invention relates to a method of transmitter tuning for single sideband transmitters, and particularly to single sideband H.F. transmitters.

In general single sideband (S.S.B.) transmitters are tuned by comparing the phases and voltages of the grid and anode signals in the output valve. This tuning is a two stage process. Firstly the anode is tuned so that the signal voltages at the grid and anode are in antiphase, then anode loading is used to adjust the ratio of anode voltage swing to grid voltage swing to a value which is known to give acceptably low intermodulation distortion.

A problem with this method of tuning is that it is not always possible in high power transmitters. It can be difficult to get access to the true control grid electrode to measure the phase and voltage of signals on it due to the physical size of the output valve. Furthermore, where a dual sideband transmitter is being operated as a single sideband transmitter this method of tuning may not be useable because the necessary instrumentation to allow measurement of the phases of the grid and anode signals is not necessarily fitted to dual sideband transmitters.

This invention was intended to produce a method of transmitter tuning overcoming these problems.

This invention provides a method of tuning a single sideband transmitter comprising an output valve amplifier and an output filter network presenting a load to the output valve, characterised by including measuring the output power of the valve, measuring the power dissipated by the valve, and carrying out the steps of;
i) adjusting the voltage of the input signal supplied to the output valve and,
ii) adjusting the load presented to the output valve by the output filter network,
   these two steps being repeated, the direction of the adjustments made being dependent on the changes in the output power and power dissipation, until desired output power and power dissipation values are reached, the load presented to the output valve by the output filter network being kept approximately real during the adjustment process.

This gives the advantage that it is not necessary to know the signal input level or phase or the phase of the output signal in order to tune the transmitter.

The transmitter must be tuned to put the valve at its operating point, that is the anode feed current and voltage across the valve must be such that the valve is at a point on its V/I characteristic curve where it acts as a linear amplifier.

Provided the load presented to the output valve by the output filter network is real the power dissipation in the output valve and the nearness of the output valve conditions to its operating point are closely related and are strongly affected by the impedance value presented to the output valve by the output filter network. It can be shown that, where the supply voltage across the output valve is constant, for a given proportional change in anode feed current about the required operating point there is a greater proportional change in power dissipation. Thus by measuring power dissipation the output valve can be set very accurately to the desired operating point by adjusting the impedance of the output filter network.

The realness of the load presented to the output valve by the output filter network can be deduced by measuring the anode efficiency of the output valve. Both anode efficiency and the power dissipation can be calculated from the input power to the valve and the output power from the valve, both of which are easily measured. The anode efficiency is simply output power divided by input power, and the value for a fully real load can easily be found for any given transmitter, while power dissipation is simply input power minus output power.

The process of adjusting the input signal voltage and the load must be an iterative process. It is not generally possible to tune the transmitter by adjusting the load until the desired operating point is reached and then adjusting the input signal to obtain the desired output power because of valve static non-linearity which means that if the valve is at its operating point at one power level and the power level is changed it will generally no longer be at its operating point at the new power level.

A convenient system of iterating is to make incremental adjustments to the input signal and load alternately.

Although the load presented to the valve by the output filter network should ideally be purely real, in practice satisfactory results can be obtained provided the load is approximately real.

Another problem in tuning is that it is possible to damage or destroy the output valve through overheating if the power dissipation within the valve becomes greater than the amount of power the cooling system can dissipate even if this is only the case for a short time. This can easily occur due to mistuning on initial set up of the transmitter. This can be prevented by comparing the power dissipation to the maximum amount of power the cooling system can dissipate and reducing the input signal to the valve if the power dissipation is above this maximum safe value during the tuning procedure.

The overheating due to overdissipation is a particular problem where a dual sideband transmitter is used to transmit a single sideband mode, because linear single sideband transmission is inherently less efficient than dual sideband transmission. As a result, for the same output power the cooling system for the output valve will have a smaller safety margin in single sideband operation than in dual sideband operation.

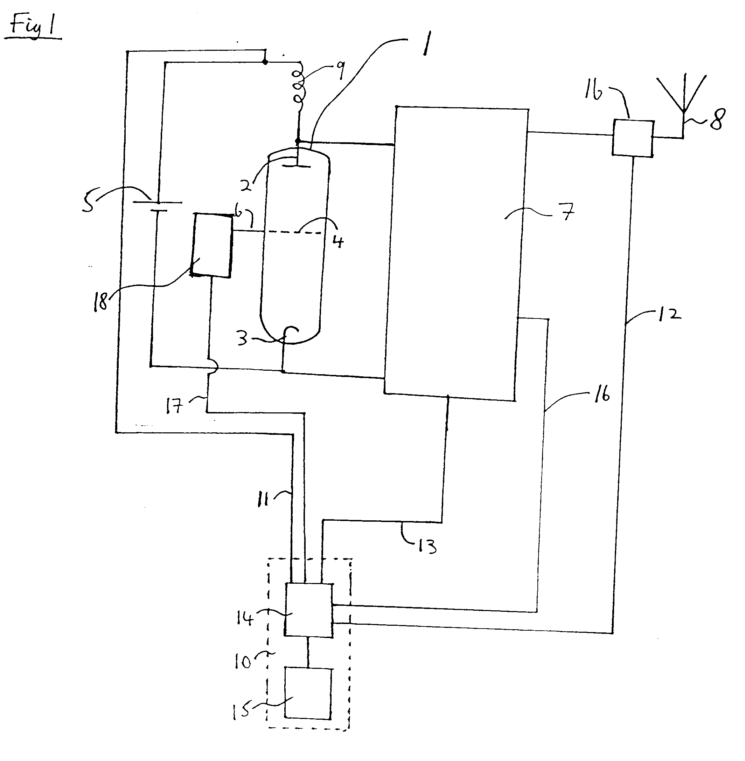

The invention will now be described by way of example only with reference to the accompanying Figure 1 which shows a transmitter suitable for tuning using the invention.

Referring to Figure 1 a single sideband transmitter is shown. This comprises an output valve 1, also known as a final stage valve. The output valve 1 includes an anode 2, cathode 3 and grid 4.

A power supply 5 applies a constant voltage, in this case 15KV between the anode 2 and the cathode 3. This voltage drives the valve 1. The power supply 5 is separated from the valve 1 by an R.F. choke 9.

An input signal is applied to the grid 4 by a line 6, this input signal is generated by other amplifying and filtering stages which are shown simply as a box 18 in Figure 1, these stages are standard and need not be shown in any detail here.

The current flow between the anode 2 and the cathode 3 is modulated by the input signal on the grid 4 from line 6 and as a result an amplified version of this input signal appears across the output valve 1, this output signal is supplied to an output filter network 7. Such output filter networks are well known in the art and need not be shown in detail here. After passing through the output filter network 7 the output signal is supplied to an antenna 8 for transmission.

In single sideband operation the output valve 1 operates as a linear amplifier, as such it always conducts current between the anode 2 and the cathode 3. For maximum linearity and thus accurate reproduction of the input signal the valve 1 must be biased to the appropriate operating point.

The input power to the valve 1 can be calculated by measuring the mean current and voltage from the power supply 5, the input power is then the product of the voltage multiplied by the current. Since the drive voltage from the power supply 5 is constant only the current actually needs to be measured. The output power is measured using a calibrated reflectometer system 16 with envelope demodulation.

The transmitter is tuned by a tuning system 10. This receives data along a line 11 giving the mean input current to the valve 1, with data along a line 12 giving the power in the load across the output filter network 7, which is measured by the reflectometer 16. It is not necessary to know the impedence presented by the filter to the output valve.

The tuning system 10 includes a data processor 14 which calculates the output power of the valve 1 using the data from line 12. The data processor 14 also calculates the input power to the valve 1 by multiplying the mean input current value from line 11 by the supply voltage value.

The data processor 14 then calculates the efficiency of the output valve 1 by dividing the output power by the input power and calculates the power dissipation in the valve 1 by subtracting the output power from the input power.

The data processor 14 then checks the efficiency value against a range of permissible efficiency values held in the memory 15. In this case the efficiency of the valve 1 will be 60% if the load presented to the valve 1 by the output filter network 7 is wholly real so the range of permissible values is centred on this and ranges from 55% to 65%. If the efficiency value is outside this range the reactive components within the filter network 7 are altered by servomechanisms in response to signals from the data processor 14 along a line 16.

When the efficiency of the valve 1 is within the permissible range of values, processor 14 makes alternate incremental changes in the input signal level and the loading presented to the valve 1 by the filter network 7. The input signal level is changed by the earlier amplifying stages 6, in response to instructions from the data processor 14 along a line 17. The loading is changed in response to instructions from the data processor along the line 16 as before.

These alternate incremental changes and measurements of the results continue as an iterative process until the desired output power and a power dissipation value corresponding to the valve 1 being at its operating point are achieved.

In an alternative embodiment a maximum permissible level of power dissipation can be held in the memory 15 and the actual value of power dissipation compared to this by the data processor 14, if the actual dissipation is over this maximum level, for example due to an initial gross mismatch, the data processor 14 will reduce the input signal level until the power dissipation falls below the maximum level. This allows overheating of the valve 1 to be avoided.

The value of 60% efficiency for a wholly real load is for a specific amplifier, however the corresponding figure for any amplifier can easily be discovered by measurement. The width of the range of permissible values depends on the degree of accuracy desired from the tuning process.

The functions of the data processor 14 and memory 15 can be carried out by an appropriately programmed general purpose computer rather than specialist units if this is more convenient.

## Claims

1. A method of tuning a single sideband transmitter comprising an output valve amplifier (1) and an output filter network (7) presenting a load to the output valve, characterised by including measuring the output power of the valve, measuring the power dissipated by the valve, and carrying out the steps of;
i) adjusting the voltage of the input signal supplied to the output valve and,
ii) adjusting the load presented to the output valve by the output filter network,
these two steps being repeated, the direction of the adjustments made being dependent on the changes in the output power and power dissipation, until desired output power and power dissipation values are reached, the load presented to the output valve by the output filter network being kept approximately real during the adjustment process.

2. A method as claimed in Claim 1 where the power dissipated by the valve is calculated by measuring the mean current and drive voltage supplied to the valve, taking the product of the mean current and voltage supplied to the valve, taking the product of the mean current and voltage to be the input power to the valve and subtracting the output power from the input power to find the power dissipated.

3. A method as claimed in Claim 2 where the drive voltage is taken to be constant and only the mean current is actually measured.

4. A method as claimed in Claim 1 in which the output power is measured using a reflectometer.
